# EUROPEAN PATENT APPLICATION

(11) **EP 2 096 686 A2**
(43) Date of publication of application: **02.09.2009**
(21) Application number: 09152536.0
(22) Date of filing: 11.02.2009
(51) Int. Cl.: H01L 33/00

(54) **Semiconductor device**

(30) Priority: 27.02.2008 JP 2008045735
(71) Applicant: Oki Data Corporation, Tokyo 108-8551 (JP)
(72) Inventor: Suzuki, Takahito, Digital Imaging Corporation, Hachioji-shi Tokyo 193-8550 (JP); Ogihara, Mitsuhiko Digital Imaging Corporation, Hachioji-shi Tokyo 193-8550 (JP); Nakai, Yusuke, Digital Imaging Corporation, Hachioji-shi Tokyo 193-8550 (JP); Sagimori, Tomohiko, Digital Imaging Corporation, Hachioji-shi Tokyo 193-8550 (JP); Furuta, Hironori, Digital Imaging Corporation, Hachioji-shi Tokyo 193-8550 (JP); Igari, Tomoki, Digital Imaging Corporation, Hachioji-shi Tokyo 193-8550 (JP); Fujiwara, Hiroyuki, Digital Imaging Corporation, Hachioji-shi Tokyo 193-8550 (JP)
(74) Representative: Betten & Resch

(57) **Abstract**

A thin-film semiconductor element is formed on a plastic substrate in a semiconductor device. A thermal expansion buffer layer is interposed between the thin-film semiconductor element and the plastic substrate. Although the thin-film semiconductor element is made from a material with a thermal expansion coefficient differing from the thermal expansion coefficient of the plastic substrate, the thermal expansion buffer layer interposed between the thin-film semiconductor element, and the plastic substrate protects the thin-film semiconductor element from damage caused by mechanical stress in the device fabrication process due to the different thermal expansion coefficients, enabling the semiconductor device to function reliably.

## Description

### BACKGROUND OF THE INVENTION

### 1. Field of the Invention

The present invention relates to a semiconductor device.

### 2. Description of the Related Art

In the recent advanced state of development of lighter, slimmer display devices, flexible displays as typified by electronic paper are much needed.

So far, the use of rigid glass substrates in slim displays has been prevalent. One disadvantage of a glass substrate is that when subjected to external impact, it may break or crack. Another disadvantage is that the comparatively high specific gravity of the glass substrate increases the weight of the device in which it is used.

The use of plastic substrates instead of glass substrates has been proposed. The use of a plastic substrate saves weight and improves impact tolerance, and because of the flexibility of a plastic substrate, display devices with a plastic substrate can be manufactured by a high throughput roll-to-roll process. Applications of plastic substrates are expected increase significantly in the display field (see, for example, Published Japanese Patent Applications by Tatsuta, No. 2002-268056, and Nishida, No. 2003-297563).

Liquid crystal devices and organic light emitting diodes (OLEDs, also referred to as electroluminescent devices or EL devices) are being developed for use as the display elements in a flexible display. Liquid crystal displays are already in extensive use on rigid substrates, and OLED displays have recently been under extensive development because, as self-emitting devices, they are thought to be capable of displaying clearer images. Although reliability problems still remain, high-quality liquid crystal displays with glass substrates are now being manufactured commercially, and high-quality prototype OLED displays with glass substrates have also been manufactured.

Forming a reliable liquid crystal or OLED display on a flexible plastic substrate, however, is extremely difficult. A liquid crystal display or OLED display that operates reliably on a plastic substrate instead of a glass substrate has yet to be created. The reason is that liquid crystal displays are vulnerable to structural degradation, and the organic light-emitting materials used in OLED displays are vulnerable to chemical degradation.

In a liquid crystal display panel, the liquid crystal material is injected into a space between opposing alignment films that are generally oriented to give the liquid crystal a ninety-degree twist. During operation, a voltage is applied across the liquid crystal to control its alignment so that light emitted from a backlight passes through or is blocked. The spacing between the two alignment films is maintained at about five micrometers (5 µm) over the entire area of the liquid crystal panel by spacers.

If a liquid crystal display with a flexible plastic substrate is used, flexing the flexible substrate changes the alignment and spacing of the alignment films, thereby distorting the controlled alignment of the liquid crystal, leading to image distortion and halation. Excessive flexing of the substrate changes the volume of the space between the alignment films and can force the liquid crystal to exude from between the films.

The basic reason for these problems is that a liquid crystal device is not an all-solid-state device. An additional problem is that since the gas barrier properties of a plastic substrate are inferior to those of a glass substrate, oxidation of the liquid crystal and bubbles due to gas permeation through the plastic substrate reduce the life of the liquid crystal display. For both of these reasons, forming a reliable liquid crystal element on a flexible plastic substrate remains a daunting task.

Since an OLED element is an all-solid-state device, an OLED display is free from the problems of image distortion, halation, and leakage of liquid crystal material. OLED displays are therefore receiving more attention than liquid crystal displays in the field of flexible display development.

The OLED materials used in OLED displays are highly vulnerable to degradation by oxidation, however, raising logistic issues, since the materials are difficult to store, as well as causing the reliability problem mentioned above. The inferior gas barrier properties of a plastic substrate require an additional gas barrier layer, but finding a gas barrier layer with suitable properties remains a problem.

In JP 2002-268056A, Tatsuta discloses a plastic substrate with an improved gas barrier layer. Even this plastic substrate, however, is inferior to glass in its gas barrier properties. The situation for OLED displays remains the same as for liquid crystal displays: it is extremely difficult to manufacture a reliable display on a plastic substrate.

A third possibility is to form a flexible display by bonding inorganic thin-film semiconductor light-emitting elements to a plastic substrate, but this strategy has received less attention because of the great difference between the thermal expansion coefficients of plastic substrate materials and inorganic semiconductor materials.

In JP 2003-297563, Nishida notes that when a luminous thin-film organic element is formed on a plastic substrate, because of the difference in their thermal expansion coefficients, an electrode or the organic layer itself may crack or peel off during the cooling and heating processes that follow thermal transfer of the organic thin-film element to the plastic substrate, and recommends the use of a plastic substrate with a thermal expansion coefficient of twenty parts per million per degree Celsius (20 ppm/°C) or less.

It can readily be envisioned that attempts to bond thin-film inorganic semiconductor elements with thermal expansion coefficients even lower than those of organic thin-film elements to plastic substrates will fail unless the thermal expansion coefficient of the plastic substrate is about the same as the thermal expansion coefficient of the semiconductor element: for example, about 6 ppm/°C. This requirement is not easily met; the thermal expansion coefficient of a plastic substrate is generally several times greater, in some cases more than ten times greater, than the thermal expansion coefficient of an inorganic semiconductor element. A fabrication process that integrates inorganic semiconductor light-emitting elements or other semiconductor circuit elements onto a plastic substrate must therefore contend with the occurrence of latent damage caused by mechanical stress during fabrication, due to the widely different coefficients of thermal expansion.

### SUMMARY OF THE INVENTION

An object of the present invention is to provide a highly reliable semiconductor device by forming a thin-film semiconductor element on a plastic substrate without damaging the semiconductor element.

This object is accomplished by interposing a thermal expansion buffer layer between the thin-film semiconductor element and the plastic substrate to absorb mechanical stress caused by different coefficients of thermal expansion.

The thermal expansion buffer layer preferably has a thermal expansion coefficient intermediate between the thermal expansion coefficients of the thin-film semiconductor element and the plastic substrate.

The thermal expansion buffer layer enables the thin-film semiconductor element to survive the device fabrication process without latent, yielding a flexible semiconductor device of high reliability.

### BRIEF DESCRIPTION OF THE DRAWINGS

In the attached drawings:
FIG. 1 is a sectional view of a semiconductor device illustrating a first embodiment of the invention;
FIG. 2 is a sectional view of a semiconductor device illustrating a second embodiment of the invention; and
FIG. 3 is a sectional view of a semiconductor device illustrating a third embodiment of the invention.

### DETAILED DESCRIPTION OF THE INVENTION

Embodiments of the invention will now be described with reference to the attached drawings, in which like elements are indicated by like reference characters.

### First Embodiment

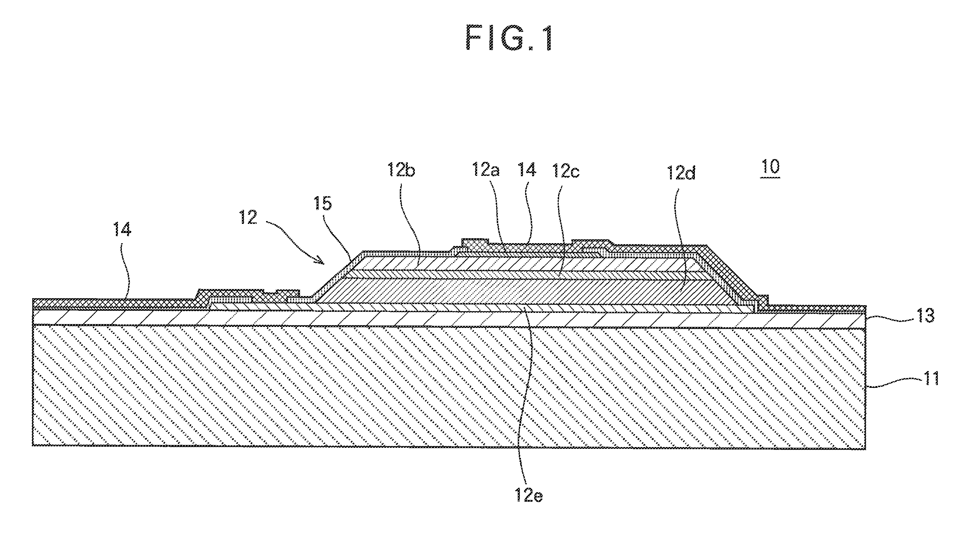

Referring to FIG. 1, the first embodiment is a semiconductor device 10 comprising an inorganic thin-film light-emitting diode (LED) 12 disposed on the upper surface of a plastic substrate 11. The plastic substrate 11 may be made from polyethylene terephthalate (PET), polyethersulfone (PES), aramid film, or polyethylene naphthalate (PEN).

It will be appreciated that a plurality of thin-film LEDs 12 may be disposed on the same plastic substrate 11. It will also be appreciated that the first embodiment is not limited to a thin-film LED 12; any type of thin-film semiconductor circuit or circuit element may be disposed on the plastic substrate 11.

A thermal expansion buffer layer 13 is formed between the thin-film LED 12 and the plastic substrate 11. The thermal expansion buffer layer 13 is interposed between the thin-film LED 12 and the plastic substrate 11 to reduce thermal stress that occurs when the thin-film LED 12 and the plastic substrate 11 expand by different amounts due to their different thermal expansion coefficients. Accordingly, the value of the thermal expansion coefficient of the thermal expansion buffer layer 13 is intermediate between the values of the thermal expansion coefficients of the thin-film LED 12 and the plastic substrate 11. The thermal expansion buffer layer 13 may be formed from an organic compound material, a metal material, an oxide material, or a nitride material. As an organic compound material, a polyimide resin or an acrylic resin, may be used. Gold, palladium, silver, titanium, or aluminum may be used as a metal material. Silicon dioxide or aluminum oxide may be used as an oxide material. Silicon nitride may be used as a nitride material.

Regardless of whether the thermal expansion buffer layer 13 is made from an organic compound material, a metal material, an oxide material, or a nitride material, the thin-film LED 12 is securely bonded to the surface of the thermal expansion buffer layer 13 by hydrogen-bonding intermolecular forces.

To ensure secure bonding by these intermolecular forces, the surface roughness of their bonded surfaces of the thin-film LED 12 and thermal expansion buffer layer 13 must be controlled. According to one exemplary control rule, the classical peak-to-valley height differences on the bonding surfaces of the plastic substrate 11 and thin-film LED 12 are held to a value equal to or less than about five nanometers (5 nm). Control of surface roughness to this degree is a known art.

To form the thin-film LED 12, thin films are grown epitaxially on a parent substrate such as, for example, a gallium arsenide substrate, a sapphire substrate, an indium phosphide substrate, a glass substrate, a quartz substrate, or a silicon substrate by a known method such as metal organic chemical vapor deposition (MOCVD), metal organic vapor phase epitaxy (MOVPE), or molecular beam epitaxy (MBE). The thin-film LED 12 is a multilayer film including at least, an upper contact layer 12a, an upper clad layer 12b, an active layer 12c, a lower clad layer 12d, and a lower contact layer 12e. The upper contact layer 12a and lower contact layer 12e form the anode and cathode of the thin-film LED 12. The thin-film LED 12 may be as thin as, for example, 5 µm or less, giving it great flexibility. Since the thin-film LED 12 is formed by semiconductor epitaxial growth processes that yield materials of extremely high quality and reliability, the thin-film LED 12 has intrinsic high quality and reliability, differing from liquid crystal and OLED devices.

When the LED thin films are epitaxially grown, a selectively etchable sacrificial layer is formed between them and the parent substrate. After epitaxial growth is completed, the sacrificial layer is selectively etched and the thin-film LED 12 is lifted off.

As an alternate method, if the thin-film LED 12 is formed from a compound semiconductor material, such as a gallium nitride, for example, that makes selective etching of a sacrificial layer difficult, the LED 12 may be reduced to a thin film by grinding and polishing the lower surface of the parent substrate until only the epitaxially grown layers needed for use as the thin-film LED 12 are left, their thickness again being about 5 µm or less.

The contact layers 12a, 12e of the thin-film LED 12 make electrical contact with thin-film wiring 14. The thin-film wiring 14 is insulated from the thin-film LED 12 and the flexible plastic substrate 11 by a dielectric layer 15. The thin-film wiring 14 and dielectric layer 15 may be formed by known methods such as photolithography. An anode driver integrated circuit (IC) and a cathode driver IC (not shown) may be connected to the thin-film wiring 14 to drive the thin-film LED 12. These integrated circuits may be formed on the same or a separate substrate and connected to the ends (not shown) of the thin-film wiring 14.

Next, the operation of the semiconductor device 10 will be described.

The thin-film LED 12 emits light when forward current is fed from its anode to its cathode.

Because of its extreme-thinness, the thin-film LED 12 can be flexed. Accordingly, even if the flexible plastic substrate 11 is flexed, the thin-film LED 12 flexes with it and continues to operate with its intrinsic high quality and reliability. As described above, in the first embodiment, a thermal expansion buffer layer 13 is interposed between the thin-film LED 12 and the plastic substrate 11. Accordingly, even though the thin-film LED 12 and the plastic substrate 11 have different thermal expansion coefficients, the thermal expansion buffer layer 13 absorbs much of the resulting mechanical stress that accompanies heating and cooling during the fabrication process, and the stress acting on the thin-film LED 12 is reduced. The thin-film LED 12 therefore remains free from damage, and its high quality and high reliability remain unimpaired.

In conventional devices of this type, if the thermal expansion coefficient difference between the thin-film LED 12 and the plastic substrate 11 is too large, the thin-film LED 12 may crack during heat treatment in the device fabrication process, but the thermal expansion buffer layer 13 interposed between the thin-film LED 12 and the plastic substrate 11 in the first embodiment protects the thin-film LED 12 from such cracks.

As noted above, liquid crystal displays that have been formed on flexible plastic substrates have been beset with problems such as image distortion, halation, and leakage of liquid crystal material, because a liquid crystal is not a solid-state device, and although OLED displays formed on flexible plastic substrates avoid these problems, their OLEO materials are highly vulnerable to degradation, raising reliability issues and logistic issues.

As an all-solid-state device, the thin-film LED 12 used in the first embodiment is free of the problems that beset flexible liquid crystal displays. Moreover, since the epitaxial growth processes used to form the thin-film LED 12 yield films of extremely high quality and reliability, the thin-film LED 12 is free of the reliability problems of a flexible OLEO display. As for flexibility, if the thin-film LED 12 has a thickness of 5 µm, for example, or less, it is thin enough to bend together with the plastic substrate 11 without compromise to its quality and reliability.

The thermal expansion coefficient of gallium arsenide, gallium nitride, and other inorganic compound semiconductor materials from which thin-film LEDs 12 are made is about 6 ppm/°C. The thermal expansion coefficient of the plastic substrate 11 differs depending on the type of material from which the plastic substrate 11 is made, but is generally several times greater, typical values being from about 15 ppm/°C to 80 ppm/°C. The thermal expansion coefficient of the thermal expansion buffer layer 13 also differs depending on the type of material from which the thermal expansion buffer layer 13 is made, but this material can be selected so that its thermal expansion coefficient is closer to the thermal expansion coefficient of the thin-film LED 12. As a result, mechanical stress on the thin-film LED 12 is reduced, the thin-film LED 12 can survive the rigors of fabrication without latent damage, and the semiconductor device 10 can function reliably over a wide temperature range.

### Second Embodiment

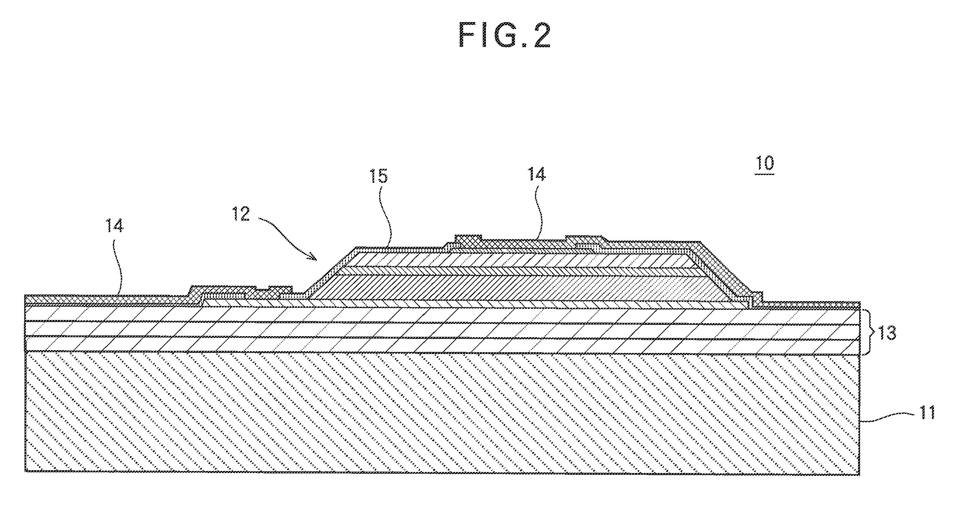

Referring to FIG. 2, the second embodiment is similar to the first embodiment except that the thermal expansion buffer layer 13 between the thin-film LED 12 and plastic substrate 11 is a multilayer with, for example, three constituent sublayers. This permits reliable bonding to the thin-film LED 12 and the plastic substrate 11 even if the thermal expansion coefficient difference between the thin-film LED 12 and the plastic substrate 11 is greater than would be permissible in the first embodiment, expanding the range of substrates on which high-quality, high-reliability thin-film LEDs 12 can be mounted.

The value of the thermal expansion coefficient of each constituent sublayer of the thermal expansion buffer layer 13 is intermediate between the values of the thermal expansion coefficients of the thin-film LED 12 and the plastic substrate 11, so that each sublayer acts to reduce the thermal stress that occurs due to the thermal expansion difference between the thin-film LED 12 and the plastic substrate 11. Each sublayer of the thermal expansion buffer layer 13 may be made from an organic compound material, a metal material, an oxide material, or a nitride material.

The semiconductor device 10 in the second embodiment operates in the same way as in the first embodiment. The thin-film LED 12 emits light when forward current is fed from anode to cathode.

As in the first embodiment, the thin-film LED 12 may be as thin as 5 µm, for example, or less, so that the thin-film LED 12 can flex with the plastic substrate 11 and still continue to operate with high quality and reliability.

The three sublayers of the thermal expansion-buffer layer 13 in the second embodiment can absorb more thermal expansion stress than the single thermal expansion buffer layer 13 in the first embodiment. Accordingly, even if the thin-film LED 12 and the plastic substrate 11 have greatly different thermal expansion coefficients, the multilayer thermal expansion buffer layer 13 in the second embodiment can protect the thin-film LED 12 from cracks and other forms of damage due to the thermal expansion difference between the thin-film LED 12 and the plastic substrate 11.

### Third Embodiment

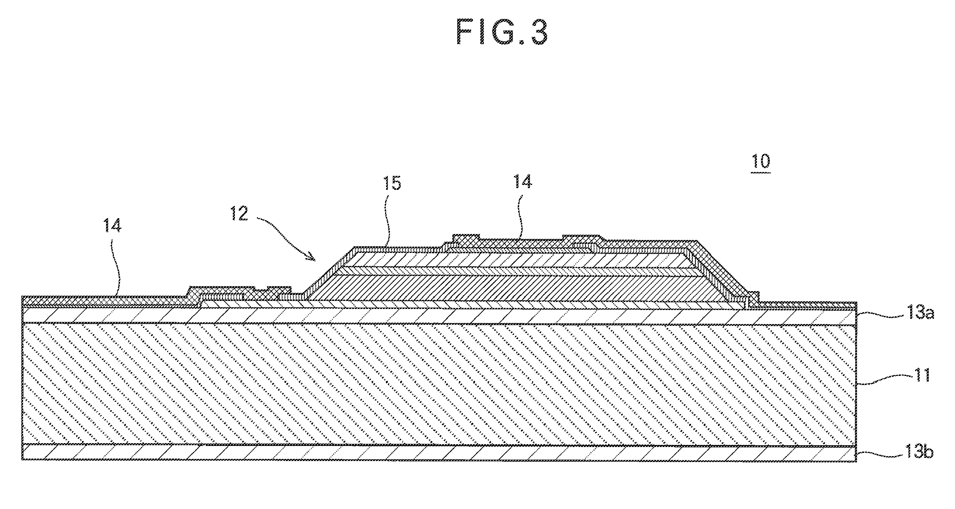

Referring to FIG. 3, the third embodiment is a semiconductor device 10 with a thin-film LED 12 formed on the upper surface of a plastic substrate 11 as in the preceding embodiments, but with one thermal expansion buffer layer 13a disposed between the plastic substrate 11 and thin-film LED 12 and another thermal expansion buffer layer 13b formed on the lower surface of the plastic substrate 11.

The thermal expansion buffer layers 13a, 13b are drawn films of an organic compound material. This organic compound may be the same organic compound as used for the plastic substrate 11, such as, for example, PET, polyimide, PES, aramid, or PEN, but the thermal expansion buffer layers 13a, 13b are drawn (stretched) when they are formed, while the plastic substrate 11 is not drawn. Accordingly, the plastic substrate 11 is thermoexpansive but the thermal expansion buffer layers 13a, 13b are thermo-shrinking: when the semiconductor device 10 is heated, the plastic substrate 11 expands but the thermal expansion buffer layers 13a, 13b contract. The degree to which the thermal expansion buffer layers 13a, 13b are drawn is selected so that the combined thermal expansion coefficient of the multilayer consisting of the plastic substrate 11 and thermal expansion buffer layers 13a, 13b matches the thermal expansion coefficient of the thin-film LED 12.

The semiconductor device 10 in the third embodiment operates in the same way as in the preceding embodiments. The thin-film LED 12 emits light when forward current is fed from anode to cathode.

As in the preceding embodiments, the thin-film LED 12 may be as thin as 5 µm, for example, or less, so that the thin-film LED 12 can flex with the plastic substrate 11 without compromise to its quality and reliability.

What is more, since the thermal expansion coefficient of the thin-film LED 12 matches the thermal expansion coefficient of the multilayer on which it is mounted, including the plastic substrate 11 and the thermal expansion buffer layers 13a, 13b formed on the upper and lower surfaces of the plastic substrate 11, in heat treatment processes performed after the thin-film LED 12 is mounted on the plastic substrate 11, the thin-film LED 12 is subjected to little or no stress due to thermal expansion. Besides protecting the thin-film LED 12 from damage during fabrication of the semiconductor device 10, this feature greatly improves the temperature tolerance of the semiconductor device 10 in the field, making it possible to use the thin-film LED 12 in extreme temperature environments without impairing the quality and reliability of the thin-film LED 12.

The invention is not limited to the materials mentioned and configurations shown in the preceding embodiments. Those skilled in the art will recognize that further variations are possible within the scope of the invention, which is defined in the appended claims.

An embodiment of the invention is summarised as follows. A thin-film semiconductor element is formed on a plastic substrate in a semiconductor device. A thermal expansion buffer layer is interposed between the thin-film semiconductor element and the plastic substrate. Although the thin-film semiconductor element is made from a material with a thermal expansion coefficient differing from the thermal expansion coefficient of the plastic substrate, the thermal expansion buffer layer interposed between the thin-film semiconductor element and the plastic substrate protects the thin-film semiconductor element from damage caused by mechanical stress in the device fabrication process due to the different thermal expansion coefficients, enabling the semiconductor device to function reliably.

## Claims

1. A semiconductor device comprising:
a plastic substrate having an upper surface and a lower surface;
a thin-film semiconductor element formed on the upper surface of the plastic substrate; and
a first thermal expansion buffer layer interposed between the thin-film semiconductor element and the plastic substrate.

2. The semiconductor device of claim 1, wherein the thin-film semiconductor element has a first thermal expansion coefficient, the plastic substrate has a second thermal expansion coefficient, and the first thermal expansion buffer layer has a third thermal expansion coefficient intermediate between the first thermal expansion coefficient and the second thermal expansion coefficient.

3. The semiconductor device of claim 1 or 2, wherein the first thermal expansion buffer layer is made from an organic compound material, a metal material, an oxide material, or a nitride material.

4. The semiconductor device of one of claims 1 to 3, wherein the first thermal expansion buffer layer is a multilayer.

5. The semiconductor device of one of claims 1 to 4, further comprising a second thermal expansion buffer layer formed on the lower surface of the plastic substrate, wherein the plastic substrate is thermoexpansive, the first and second thermal expansion buffer layers are thermo-shrinking, the thin-film semiconductor element has a first thermal expansion coefficient, and the plastic substrate and the first and second thermal expansion butter layers have a combined thermal expansion coefficient matching the first thermal expansion coefficient.

6. The semiconductor device of claim 5, wherein the first and second thermal expansion buffer layers are made from an organic compound.

7. The semiconductor device of claim 6, wherein the first and second thermal expansion buffer layers are drawn layers.

8. The semiconductor device of claim 7, wherein the first and second thermal expansion buffer layers and the plastic substrate are made from mutually identical materials.

9. The semiconductor device of one of claims 1 to 8, wherein the thin-film semiconductor element is made from inorganic materials.

10. The semiconductor device of one of claims 1 to 9, wherein the thin-film semiconductor element has a thickness of at most five micrometers.
